# EUROPEAN PATENT SPECIFICATION

(11) **EP 2 815 868 B1**
(45) Date of publication and mention of the grant of the patent: **29.03.2017**
(21) Application number: 13748541.3
(22) Date of filing: 13.02.2013
(51) Int. Cl.: B29C 59/02, H01L 21/027

(54) **IMPRINT DEVICE AND IMPRINT METHOD**
PRÄGUNGSVORRICHTUNG UND PRÄGUNGSVERFAHREN
DISPOSITIF D'IMPRESSION ET PROCÉDÉ D'IMPRESSION

(30) Priority: 14.02.2012 JP 2012030014
(43) Date of publication of application: 24.12.2014
(73) Proprietor: Scivax Corporation, Kawasaki-shi, Kanagawa 212-0032 (JP)
(72) Inventor: KAWAGUCHI Hirosuke, Kawasaki-shi Kanagawa 212-0032 (JP); TANAKA Satoru, Kawasaki-shi Kanagawa 212-0032 (JP)
(74) Representative: Gille Hrabal
(86) International application number: PCT/JP2013/053425
(87) International publication number: WO 2013/122109

(56) References cited:
- EP-A1- 2 239 127
- JP-A- H06 114 933
- JP-A- 2006 018 977
- JP-A- 2008 155 521
- JP-A- 2008 230 027
- JP-A- 2011 020 272
- US-A- 3 860 382
- US-A1- 2009 061 035
- US-A1- 2011 233 821

## Description

### Technical Field

The present disclosure relates to an imprinting device according to claim 1 and an imprinting method according to claim 10 which transfer a micropattern of a die to a molding target.

### Background Art

Conventionally, a nano-imprinting technology is known which is a method for forming a micropattern in micro-order or nano-order. Such a technology is to pressurize a die having a micropattern against a molding target like a resin, and to transfer such a pattern to the molding target using heat or light (see, for example, Patent Literature 1). In addition, in order to increase a transfer area, an imprinting device that pressurizes a flexible die or molding target by fluid pressure is proposed (see, for example, Patent Literature 2).

### Citation List

### Patent Literature

Patent Literature 1: WO2004/062886
Patent Literature 2: JP 2009-154393 A (see also EP 2 239 127 A1: an imprinting device and an imprinting method)

### Summary of Invention

### Technical Problem

According to conventional imprinting devices, however, a cylindrical bellows is utilized to form a depressurizing room. Hence, when a rectangular stage is applied, a large bellows is necessary, and thus the device size increases.

In addition, according to the conventional devices, in order to surely eliminate a fluid between the die and the molding target, it is necessary to additionally provide a separator for separating the die from the molding target. This further increases the size of the devices, and also increases the costs.

Therefore, it is an objective of the present disclosure to provide an imprinting device and an imprinting method which can downsize the device and which reduce costs.

### Solution to Problem

To accomplish the above objective, an imprinting device of the present disclosure transfers a molding pattern of a die to a molding target, and the imprinting device includes: a stage and a cover that depress the die and the molding target; a frame formed with a hole into which the stage is fitted and surrounding an outer circumference of the stage; a first moving means for relatively moving the stage and the cover in a direction coming close to or becoming apart from each other; a second moving means for relatively moving the cover and the frame in a direction coming close to or becoming apart from each other; a first depressurizing means for depressurizing a depressurizing room formed any one of the cover, the die or the molding target, and the stage, and further the frame, and eliminating a fluid present between the die and the molding target; and a second depressurizing means for eliminating a fluid present in a space formed between the cover and the die or the molding target.

In this case, it is preferable that the frame should include a fluid spray means for spraying a fluid between the die and the molding target. The first depressurizing means and the second depressurizing means may include a communication channel causing the space and the depressurizing room to be in communication with each other. It is preferable that the imprinting device should further include space sealing means for sealing the space and depressurizing-room sealing means for sealing the depressurizing room. It is preferable that the frame should have the fluid spray means at locations facing with each other across the molding target. It is preferable that the imprinting device should further include temperature adjusting means for adjusting a temperature of the molding target. The imprinting device may further include light emitting means for emitting light to the molding target. Still further, the imprinting device may further include carrying means including a feeding roll that supplies the molding target, and a collecting roll that collects the molding target to which the molding pattern has been transferred.

An imprinting method of the present disclosure is for depressing a die and a molding target between a stage and a cover, and transferring a molding pattern of the die to the molding target, and the method includes: a disposing step for disposing the die and the molding target on the stage or the cover; a holding step for holding either one of the die and the molding target located at the cover side by a frame formed with a hole into which the stage is fitted and surrounding an outer circumference of the stage, and the cover; a separating step for separating the stage and the cover relative to each other; a first eliminating step for eliminating a fluid present in a space formed between the cover and the die or the molding target; a second eliminating step for eliminating a fluid between the die and the molding target; an intimate contact step for causing the die and the molding target to intimately contact with each other; and a transfer step for transferring the molding pattern of the die to the molding target.

In this case, it is preferable that the imprinting method should further include a demolding step for forming a space between the die and the molding target by relatively moving the stage and the frame, and spraying a fluid to the space from fluid spray means provided in the frame. In addition, in the transfer step, thermal imprinting of heating the molding target to a temperature equal to or higher than a glass transition temperature, and of depressing the molding target, or photo imprinting of depressing the die and the molding target, and of emitting light to the molding target is applicable.

### Advantageous Effects of Invention

The imprinting device and imprinting method of the present disclosure utilize, instead of a bellows conventionally applied, a frame formed with a hole into which a stage can be fitted and surrounding the outer circumference of the stage, and relatively move the frame to the stage and a cover to form a depressurizing room. Hence, the device can be downsized. In addition, either one of the die and the molding target is held by the cover and the frame, and the stage and the cover are relatively moved to each other. Hence, the stage, the frame, and the cover also serve as separating means. Therefore, the device can be further downsized, and costs can be reduced.

### Brief Description of Drawings

FIG. 1 is a partial cross-sectional view illustrating an imprinting device of the present disclosure;
FIG. 2 is a partial cross-sectional view illustrating the imprinting device of the present disclosure;
FIG. 3 is a partial cross-sectional view illustrating the imprinting device of the present disclosure;
FIG. 4 is a plan view taken along a line I-I in FIG. 1; and
FIG. 5 is a partial cross-sectional view illustrating the imprinting device of the present disclosure.

### Description of Embodiments

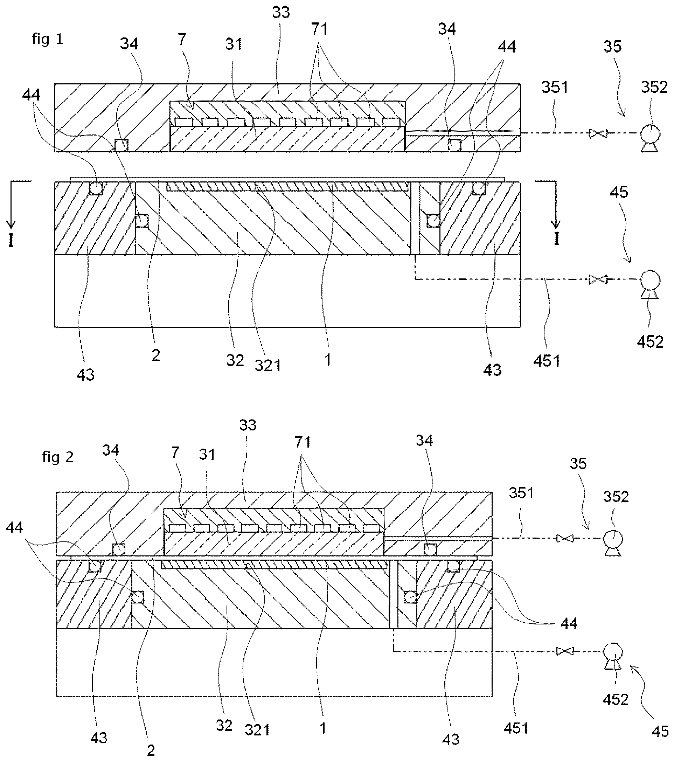

As illustrated in FIGS. 1 to 3, an imprinting device of the present disclosure is to transfer a molding pattern of a die 1 to a molding target 2, and mainly includes a stage 32 and a cover 33 to pressurize the die 1 against the molding target 2, a frame 43 formed with a hole where the stage 32 can be fitted and surrounding the stage 32, first moving means (unillustrated) for relatively moving the stage 32 and the cover 33 in a direction coming close or distant from each other, second moving means 46 for relatively moving the cover 33 and the frame 43 in a direction coming close or distant from each other, first depressurizing means 45 for depressurizing a depressurizing room 40 formed by any one of the cover 33, the die 1 or the molding target 2, and the stage 32, and further the frame 43, and eliminating a fluid between the die 1 and the molding target 2, and second depressurizing means 35 for eliminating a fluid in a space formed between the cover 33 and the die 1 or the molding target 2.

In this specification, the die 1 means one formed of, for example, "metal like nickel", "ceramics", "carbon material like glass-like carbon", or "silicon", etc., and having a predetermined molding pattern on one end face (molding face). This molding pattern can be formed by performing precision machining on the molding face. In addition, it can be formed by performing a semiconductor microfabrication technology like etching on a silicon substrate, or by performing metal plating on a surface of the silicon substrate through electroforming like nickel plating, and then peeling the metal plating layer. In addition, a resin-made die formed through imprinting is also applicable. In this case, the die may be formed as a film having flexibility relative to a molding-target face of the molding target. Needless to say, the material and manufacturing method of the die 1 are not limited to any particular ones as long as a molding pattern can be transferred.

The molding pattern formed on the die 1 is not limited to a geometrical shape including concavities and convexities, and can be one to transfer a predetermined surface condition like a transfer of a mirror surface having a predetermined surface roughness. In addition, the molding pattern has the minimum sizes of a width of a convexity in the planar direction and a width of a concavity formed in various sizes, such as equal to or smaller than 100 µm, equal to or smaller than 10 µm, equal to or smaller than 2 µm, equal to or smaller than 1 µm, equal to or smaller than 100 nm, and equal to or smaller than 10 nm. Still further, the size in the depthwise direction is also formed in various sizes, such as equal to or greater than 10 nm, equal to or greater than 100 nm, equal to or greater than 200 nm, equal to or greater than 500 nm, equal to or greater than 1 µm, equal to or greater than 10 µm, and equal to or greater than 100 µm.

Moreover, the shape of the surface (molding face) where the molding pattern of the die is formed is not limited to a plane. For example, the molding face may be formed in a tridimensional shape including a curved face like a die to transfer a MOTH-EYE structure on the curved face of a lens.

The molding target 2 means a substrate or a film formed of a resin, an inorganic compound or a metal, or one having a molding-target layer 21 formed on the substrate or the film and formed of a resin, an inorganic compound or a metal. Example resins applied to the molding target 2 are a photo-curable resin, a thermosetting resin, and a thermoplastic resin.

Example photo-curable resin or thermosetting resin is epoxide-containing compounds, (metha) acrylate ester compounds, or unsaturated hydrocarbon-radial containing compounds of vinyl radial and allyl radial, such as vinyl ether compounds, bisallylnadimide compounds. In this case, for the purpose of a thermal polymerization, a polymerization reaction radial containing compound can be applied in solo, or an initiator with a thermal reactivity may be added to improve the thermal curing. In addition, a photoreactive initiator may be added to let a polymerization reaction advanced upon irradiation with light, thereby forming a molding pattern. Example radial initiators with a thermal reactivity suitable are organic peroxide and azo compound, and example photoreactive radial initiators suitable are acetophenone derivative, benzophenone derivative, benzoin ether derivative, and xanthone derivative. The reactive monomer may be utilized in a solventless form, or may be dissolved in a solvent and desolvated after application.

Example thermoplastic resins are olefin-based resins, such as cyclic-olefin ring-open polymer/hydrogen added substance (COP) and cyclic-olefin copolymer (COC), an acrylic resin, polycarbonate, a vinyl-ether resin, fluorine resins, such as perfluoroalkoxyalkane (PFA) or polytetrafluoroethylene (PTFE), polystyrene, a polyimide-based resin, and a polyester-based resin.

The molding target 2 may be formed as a flexible film, or may be one having a layer formed on a substrate formed of an inorganic compound like silicon or metal.

In FIG. 1, the die 1 and the molding target 2 are disposed at the stage-32 side and the cover-33 side, respectively, but the molding target 2 and the die 1 may be disposed at the stage-32 side, the cover-33 side, respectively.

The cover 33 is to pressurize the die 1 and the molding target 2 with each other together with the stage 32. In addition, the cover 33 is formed larger than the stage 32 so as to hold the die 1 or the molding target 2 together with the frame 43. The material of the cover 33 is not limited to any particular one as long as it has pressure resistance and heat resistance under a molding condition during an imprinting process, and for example, a metal like stainless steel is applicable. When the cover 33 is provided with a light emitting part 7, as illustrated in FIG. 1, a transparent member 31 like a glass can be disposed on a part of the cover 33.

The stage 32 is to pressurize the die 1 and the molding target 2 together with the cover 33. A pressure receiving face 321 of the stage 32 at a side contacting the die 1 or the molding target 2 is formed so as to be sufficiently wide and smooth. This pressure receiving face 321 can be formed as a plane or a curved face in accordance with the shape of the die 1 or molding target 2 supported by the pressure receiving face. The material is not limited to any particular one as long as it has pressure resistance and heat resistance under the molding condition during an imprinting process, and for example, a metal like stainless steel is applicable. In addition, when the die 1 or the molding target 2 is heated from the stage-32 side, it is preferable that a material with a high thermal conductivity like a metal should be applied. Conversely, when the die 1 or the molding target 2 is heated from the cover-33 side, a material having a low thermal conductivity may be applied to prevent heat from escaping to the stage-32 side, but in order to suppress uneven heating, it is preferable that the pressure receiving face 321 should be formed of a material having a high thermal conductivity. In the case of a photo-imprinting, when a light source is disposed at the stage-32 side, a transparent material like a glass is applicable. In order to suppress an unnecessary transfer impress on the molding target 2, the die 1 and the stage 32 may be formed integrally with each other. For example, according to conventional technologies, a pattern is formed by electroforming, and only the pattern portion is cut out and used, but one having undergone electroforming and having the pattern portion not cut out may be directly used.

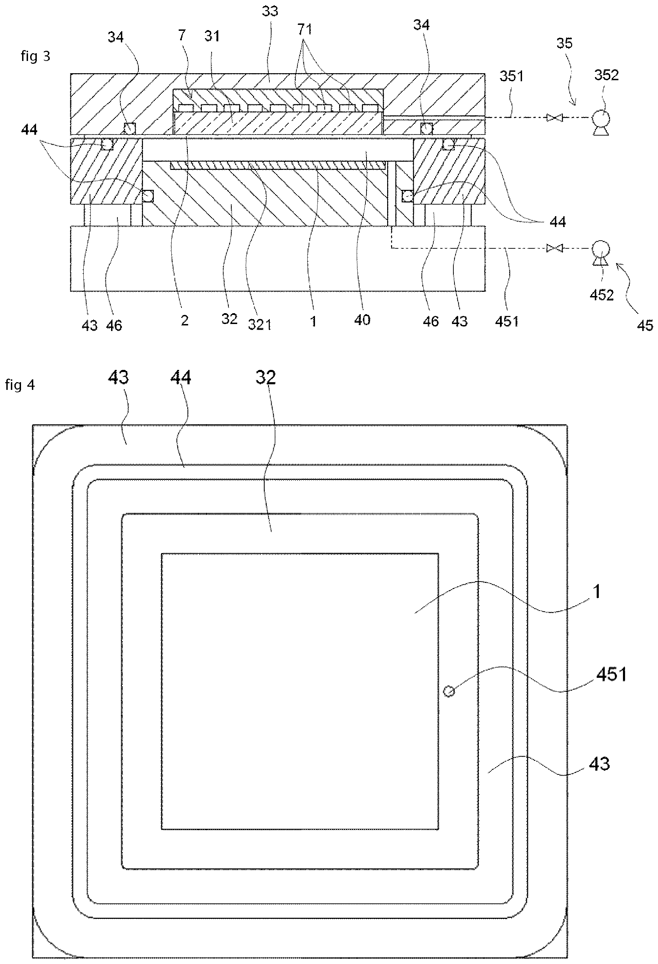

The frame 43 is disposed so as to surround the outer circumference of the stage 32, and can be formed in a cylindrical shape having a hole where the stage 32 can be fitted. By forming the frame as explained above, as illustrated in FIG. 3, the frame 43 can be moved relative to the stage 32 to form the depressurizing room 40. In this case, the depressurizing room 40 is to depressurize the atmosphere around the die 1 and the molding target 2, in particular, the atmosphere between the die 1 and the molding target 2. Hence, the gas present between the die 1 and the molding target 2, and thus between those and the stage 32 can be eliminated, enabling a uniform press of the die 1 against the molding target 2. The material of the frame 43 is not limited to any particular one as long as it has pressure resistance and heat resistance under the molding condition during an imprinting process, and for example, a metal like stainless steel is applicable.

In addition, in order to surely seal the depressurizing room 40, depressurizing room sealing means 44 for sealing a space between the frame 43 and the stage 32, and a space between the frame 43 and the die 1 or the molding target 2 can be further provided. For example, as illustrated in FIG. 1, as the depressurizing room sealing means 44, an O-ring is prepared, a concaved groove shallower than the diameter of the cross-section of the O-ring is formed in the end of the frame 43 at the cover-33 side, and the O-ring is placed in this groove. In addition, a concaved groove shallower than the diameter of the cross-section of the O-ring is formed in the outer circumference of the stage 32 (at the frame-43 side), and the O-ring is placed in this groove. Needless to say, a concaved groove shallower than the diameter of the cross-section of the O-ring may be formed in the inner circumference of the frame 43 (at the stage-32 side), and the O-ring may be placed in this groove.

The first moving means is not illustrated in the figures, but can be an arbitrary mechanism that causes the cover 33 and the stage 32 to come close to or go apart from each other. For example, the stage 32 is fixed, and the cover 33 is moved by a hydraulic or pneumatic cylinder, or is moved by an electric motor and a ball screw. Needless to say, the cover 33 may be fixed and the stage 32 may be moved by the similar mechanism.

In addition, the first moving means may apply, to the cover 33 and the stage 32, pressure to transfer the pattern of the die 1 to the molding target 2, but pressurizing means that applies pressure to the cover 33 and the stage 32 can be additionally provided. In this case, a hydraulic or pneumatic cylinder may apply pressure, or an electric motor and a ball screw may apply pressure.

The second moving means 46 can be an arbitrary mechanism that causes the cover 33 and the frame 43 to come close to or go apart from each other. For example, the frame 43 is moved by a hydraulic or pneumatic cylinder, or is moved by an electric motor and a ball screw. Needless to say, the cover 33 may be moved by the similar mechanism.

The first depressurizing means 45 depressurizes the depressurizing room 40 formed by any one of the cover 33, the die 1 or the molding target 2, and the stage 32, and, the frame 43, and eliminates a fluid at least between the die 1 and the molding target 2. For example, the first depressurizing means includes a depressurizing room gas supply/discharge channel 451 connected to the depressurizing room 40, and a first depressurizing pump 452 that discharges the gas in the depressurizing room 40 through the depressurizing room gas supply/discharge channel 451. The depressurizing room gas supply/discharge channel 451 may be provided with an on-off valve.

The second depressurizing means 35 is to prevent the die 1 or the molding target 2 from being warped toward the depressurizing room 40 due to a pressure difference between a slight space formed between the cover 33 and the die 1 or the molding target 2 and the depressurizing room 40 when the depressurizing room 40 is depressurized. The second depressurizing means 35 includes, for example, a space gas supply/discharge channel 351 connected to the aforementioned space, and a second depressurizing pump 352 that discharges the gas in the space through the space gas supply/discharge channel 351. The space gas supply/discharge channel 351 may be provided with an on-off valve. According to this structure, before the depressurizing room 40 is depressurized, a fluid in such a space can be eliminated. It is not illustrated in the figure but the first depressurizing pump 452, the space gas supply/discharge channel 351, and the depressurizing room gas supply/discharge channel 451 may be connected together by a three-way valve, and the first depressurizing pump may be commonly utilized to omit the second depressurizing pump 352.

It is preferable to eliminate the fluid in that space before the depressurizing room 40 is depressurized, but a communication channel that causes such a space and the depressurizing room to be in communication with each other may be provided to simultaneously eliminate the fluid in that space and the depressurizing room.

In order to surly seal a space formed between the cover 33 and the die 1 or the molding target 2, space sealing means 34 that seal the space between the cover 33 and the die 1 or the molding target 2 may be provided. For example, as illustrated in FIG. 3, as the space sealing means 34, an O-ring is prepared, a concaved groove shallower than the diameter of the cross-section of the O-ring is formed in a portion of the cover 33 facing the frame 43, and the O-ring is place in this groove. Hence, the molding target 2 is held by the cover 33 and the frame 43, and the cover 33 and the molding target 2 can be intimately in contact with each other, thereby sealing the space.

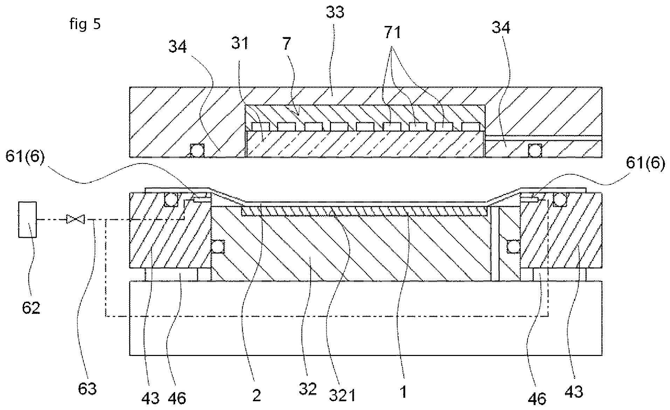

Moreover, as illustrated in FIG. 5, the imprinting device of the present disclosure may include fluid spray means 6 which sprays fluid like gas between the die 1 and the molding target 2 and which is provided in the frame. According to this structure, the cover 33 is moved apart from the stage 32 while holding the molding target 2 (or the die 1) by the cover 33 and the frame 43, a space is formed after a pattern transfer between the die 1 and the end of the molding target 2 intimately contacting with each other, and a fluid is sprayed to this space to perform demolding.

The fluid spray means 6 mainly includes, for example, spray ports 61 provided in the internal side wall of the frame 43 and spraying the fluid between the die 1 and the molding target 2, flow-speed adjusting means (unillustrated) for adjusting the flow speed of the fluid sprayed from the spray ports 61, a demolding fluid supply source 62 that supplies the fluid to the spray ports 61, and a demolding fluid supply channel 63 causing the fluid of the demolding fluid supply source 62 to flow to the spray ports 61.

The spray ports 61 can be formed as slits formed along the internal side wall of the frame 43. The width of slit can be adjusted in accordance with the sticking force between the die 1 and the molding target 2, etc., but for example, the width can be 0.2 to 0.5 mm. In addition, a multi-nozzle having multiple holes provided at an appropriate interval along the end of the molding target 2 is applicable. The angle of the spray port 61 is directed in the sticking-face direction of the die 1 and the molding target 2, or is parallel with the sticking-face direction.

The spray ports 61 is provided in at least two directions opposite to each other across the molding target 2, preferably, four directions. Hence, the fluid sprayed from the opposite positions collides at the center between the die 1 and the molding target 2. In this case, the fluid loses the velocity, and becomes static pressure from dynamic pressure, and the static pressure at the colliding portion becomes higher than the pressure by the upper face of the molding target 2. Hence, the molding target 2 is lifted up. The energy of the fast-speed sprayed fluid is converted into static pressure, and the fluid instantaneously dissipates peeling caused at a wall face, eddying flow, and shearing force. Therefore, the pattern transferred to the molding target 2 is prevented from being damaged.

The flow-speed adjusting means is not limited to any particular one as long as it can adjust the flow speed of the fluid sprayed from the spray ports 61, but for example, a structure that adjusts the flow speed based on pressure and a spraying time is applicable. More specifically, a fluid pressurized at 0.2 to 0.5 MPa by an accumulator may be sprayed as pulses at 50 to 300 ms.

The demolding fluid supply source 63 may be an air compressor that supplies gas to the spray ports 61 or a tank that reserves compressed gas.

When the imprinting device of the present disclosure is applied to a thermal imprinting process, it is not illustrated in the figures but the imprinting device further includes temperature adjusting means for adjusting the temperature of the molding target 2 by heating or cooling the molding target 2. The temperature adjusting means can be a heater or a cooler that heats/cools the molding target 2 directly or indirectly.

The heater is not limited to any particular one as long as it can heat either one of or both of the die 1 and the molding target 2 to a predetermined temperature, e.g., equal to or higher than the glass transition temperature of the molding target 2 or equal to or higher than the melting temperature thereof. The molding target 2 can be heated from the stage-32 side or from the cover-33 side. For example, a heater may be provided in the stage 32 or the cover 33 to heat the die 1 or the molding target 2. In addition, heating can be performed using a heated liquid or gas.

The cooler is not limited to any particular one as long as it can cool either one of or both of the die 1 and the molding target 2 to a predetermined temperature, e.g., less than the glass transition temperature of the molding target 2 or less than the melting temperature thereof. The molding target 2 can be cooled from the stage-32 side or from the cover-33 side. For example, a water jacket for cooling is provided in the stage 32 or the cover 33 to cool the die 1 or the molding target 2.

When the imprinting device of the present disclosure is applied to a photo imprinting process, light emitting means 7 including a light source 71 that emits electromagnetic waves of a predetermined wavelength to the molding target 2 is provided. As illustrated in FIG. 1, the light emitting means 7 may be provided in the cover 33, or may be provided at the stage-32 side. In this case, in order to adjust the temperature of the molding target 2 to an appropriate temperature, the aforementioned temperature adjusting means may be further provided.

It is not illustrated in the figure but the imprinting device may further include carrying means for carrying the molding target 2 to the imprinting device of the present disclosure. For example, a feeding roll that supplies the resin film (molding target) and a collecting roll that collects the resin film to which the molding pattern is transferred are disposed so as to face with each other across the stage 32. This structure enables a successive pattern transfer.

Next, an explanation will be given of an imprinting method of the present disclosure together with an operation of the imprinting device of the present disclosure. The imprinting method of the present disclosure is to depress the die 1 and the molding target 2 between the stage 32 and the cover 33, and to transfer the molding pattern of the die 1 to the molding target 2. The imprinting method mainly includes a disposing step for disposing the die 1 and the molding target 2 on the stage 32 or the cover 33, a holding step for holding either one of the die 1 and the molding target 2 located at the cover-33 side by the frame 43 formed with a hole where the stage 32 can be fitted and surrounding the outer circumference of the stage 32, and the cover 33, a separating step for separating the stage 32 and the cover 33 relative to each other, a first eliminating step for eliminating a fluid in a space formed between the cover 33 and the die 1 or the molding target 2, a second eliminating step for eliminating a fluid between the die 1 and the molding target 2, an intimate contact step for causing the die 1 and the molding target 2 to intimately contact with each other, and a transfer step for transferring the molding pattern of the die 1 to the molding target 2.

In the disposing step, as illustrated in FIG. 1, the die 1 and the molding target 2 are disposed on the stage 32. At this time, one disposed at the stage-32 side is disposed so as not to overlap the frame 43 on the stage 32, and one disposed at the cover-33 side is disposed so as to at least partially overlap the frame 43 so that it is held by the frame 43 and the cover 33 and becomes separable from the stage 32.

In the holding step, as illustrated in FIG. 2, the cover 33 and the frame 43 are moved in a direction becoming close to each other, and either one of the die 1 and the molding target 2 located at the cover-33 side (in FIG. 2, the molding target 2) is held by the cover 33 and the frame 43.

In the separating step, as illustrated in FIG. 3, with the die 1 or the molding target 2 being held by the cover 33 and the frame 43, the cover 33 and the stage 32 are moved in a direction becoming distant from each other. Hence, a space can be formed between the die 1 and the molding target 2, and thus the depressurizing room 40 can be formed.

In the first eliminating step, a fluid in the space formed between the cover 33 and either one of the die 1 and the molding target 2 located at the cover-33 side (in FIG. 3, the molding target 2) is eliminated, and the die 1 or the molding target 2 is suctioned to the cover 33.

In the second eliminating step, the depressurizing room 40 is depressurized, and a fluid present in the space between the die 1 and the molding target 2 formed through the separating step.

In the intimate contact step, as illustrated in FIG. 2, the cover 33 and the stage 32 are moved in a direction becoming close to each other, thereby causing the die 1 and the molding target 2 to intimately contact with each other.

In the transfer step, the molding pattern of the die 1 is transferred to the molding target 2 through thermal imprinting or photo imprinting. In the case of the thermal imprinting, first, the molding target 2 is heated to a temperature equal to or higher than the glass transition temperature by the heater, and force is applied to the cover 33 and the stage 32 by the first moving means or pressurizing means. In this case, the die 1 and the molding target 2 are depressed, and the molding pattern is transferred to the molding target 2. Next, the temperature of the molding target is lowered below the glass transition temperature by the cooler, and thus the molding pattern is settled on the molding target 2. Conversely, in the case of the photo imprinting, the molding target 2 is heated to a temperature equal to or higher than the glass transition temperature as needed by the heater, and force is applied to the cover 33 and the stage 32 by the first moving means or pressurizing means. In this case, the die 1 and the molding target 2 are depressed, and thus the molding pattern is transferred to the molding target 2. Next, light with a predetermined wavelength is emitted to the molding target 2 from the light emitting means, and thus the molding pattern is settled on the molding target 2.

A demolding step is not limited to any particular process as long as the die 1 can be separated from the molding target 2, but for example, as illustrated in FIG. 5, the stage 32 and the frame 43 are moved relative to each other to form a space between the die 1 and the molding target 2 intimately contacting with each other. Next, the fluid spray means provided in the frame 43 sprays a fluid to that space. Hence, the die 1 can be quickly demolded from the molding target 2.

### Reference Signs List

- 1: Die
- 2: Molding target
- 6: Fluid spray means
- 7: Light emitting means
- 32: Stage
- 33: Cover
- 34: Space sealing means
- 35: Second depressurizing means
- 40: Depressurizing room
- 43: Frame
- 44: Depressurizing room sealing means
- 45: First depressurizing means
- 46: Second moving means

## Claims

1. An imprinting device that transfers a molding pattern of a die (1) to a molding target (2), the imprinting device comprising:
a stage (32) and a cover (33) that depress the die (1) and the molding target (2);
a frame (43) formed with a hole into which the stage (32) is fitted and surrounding an outer circumference of the stage (32);
a first moving means for relatively moving the stage (32) and the cover (33) in a direction coming close to or becoming apart from each other;
a second moving means for relatively moving the cover (33) and the frame (43) in a direction coming close to or becoming apart from each other;
a first depressurizing means (45) for depressurizing a depressurizing room (40) formed any one of the cover (33), the die (1) or the molding target (2), and the stage (32), and further the frame (43), and eliminating a fluid present between the die (1) and the molding target (2); and
a second depressurizing means (35) for eliminating a fluid present in a space formed between the cover (33) and the die (1) or the molding target (2).

2. The imprinting device according to claim 1, wherein the frame (43) includes a fluid spray means (6) for spraying a fluid between the die (1) and the molding target (2).

3. The imprinting device according to claim 1 or 2, wherein the first depressurizing means (45) and the second depressurizing means (35) include a communication channel causing the space and the depressurizing room (40) to be in communication with each other.

4. The imprinting device according to any one of claims 1 to 3, further comprising a space sealing means (34) for sealing the space.

5. The imprinting device according to any one of claims 1 to 4, further comprising depressurizing-room sealing means (44) for sealing the depressurizing room (40).

6. The imprinting device according to claim 2, wherein the frame (43) has the fluid spray means (6) at locations facing with each other across the molding target (2).

7. The imprinting device according to any one of claims 1 to 6, further comprising temperature adjusting means for adjusting a temperature of the molding target (2).

8. The imprinting device according to any one of claims 1 to 7, further comprising light emitting means (7) for emitting light to the molding target (2).

9. The imprinting device according to any one of claims 1 to 8, further comprising carrying means including a feeding roll that supplies the molding target (2), and a collecting roll that collects the molding target (2) to which the molding pattern has been transferred.

10. An imprinting method for depressing a die (1) and a molding target (2) between a stage (32) and a cover (33), and transferring a molding pattern of the die (1) to the molding target (2), the method comprising:
a disposing step for disposing the die (1) and the molding target (2) on the stage (32) or the cover (33);
a holding step for holding either one of the die (1) and the molding target (2) located at the cover side by a frame (43) formed with a hole into which the stage (32) is fitted and surrounding an outer circumference of the stage (32), and the cover (33);
a separating step for separating the stage (32) and the cover (33) relative to each other;
a first eliminating step for eliminating a fluid present in a space formed between the cover (33) and the die (1) or the molding target (2);
a second eliminating step for eliminating a fluid between the die (1) and the molding target (2);
an intimate contact step for causing the die (1) and the molding target (2) to intimately contact with each other; and
a transfer step for transferring the molding pattern of the die (1) to the molding target (2).

11. The imprinting method according to claim 10, further comprising a demolding step for forming a space between the die (1) and the molding target (2) by relatively moving the stage (32) and the frame (43), and spraying a fluid to the space from fluid spray means (6) provided in the frame (43).

12. The imprinting method according to claim 10 or 11, wherein in the transfer step, the molding target (2) is heated to a temperature equal to or higher than a glass transition temperature, and then the molding target (2) is depressed.

13. The imprinting method according to claim 11 or 12, wherein in the transfer step, the die (1) and the molding target (2) are depressed, and then light is emitted to the molding target (2).

## Patentansprüche

1. Druckvorrichtung, welche ein Formmodell von einer Form (1) auf ein Formziel (2) überträgt, wobei die Druckvorrichtung
eine Plattform (32) und eine Abdeckung (33), welche die Form (1) und das Formziel (2) herabdrücken;
einen Rahmen (43), welcher ein Loch aufweist, in das die Plattform (32) eingepasst ist und welcher den Außenumfang der Plattform (32) umgibt;
ein erstes Bewegungsmittel zum relativen Bewegen der Plattform (32) und der Abdeckung (33) in eine Richtung, in der sie nah zueinander kommen oder sich voneinander entfernen;
ein zweites Bewegungsmittel zum relativen Bewegen der Abdeckung (33) und des Rahmens (43) in eine Richtung, in der sie nah zueinander kommen oder sich voneinander entfernen;
ein erstes Druckverringerungsmittel (45) zum Dekomprimieren eines Dekompressionsraums (40), welcher durch die Abdeckung (33), die Form (1) oder das Formziel (2), und die Plattform (32) und zusätzlich den Rahmen (43) gebildet wird, und zum Entfernen einer Flüssigkeit, die sich zwischen der Form (1) und dem Formziel (2) befindet; und
ein zweites Druckverringerungsmittel (35) zum Entfernen einer Flüssigkeit, die sich in einer Lücke befindet, die zwischen der Abdeckung (33) und der Form (1) oder dem Formziel (2) gebildet wird,
umfasst.

2. Die Druckvorrichtung nach Anspruch 1, wobei der Rahmen (43) eine Flüssigkeitsversprühvorrichtung (6) zum Versprühen einer Flüssigkeit zwischen die Form (1) und das Formziel (2) umfasst.

3. Die Druckvorrichtung nach Anspruch 1 oder 2, wobei das erste Druckverringerungsmittel (45) und das zweite Druckverringerungsmittel (35) einen Verbindungskanal, welcher bewirkt, dass die Lücke und der Dekompressionsraum (40) in Verbindung zueinander stehen, umfassen.

4. Die Druckvorrichtung nach einem der Ansprüche 1 bis 3, welche zusätzlich eine Lückenabdichtvorrichtung (34) zum Abdichten der Lücke umfasst.

5. Die Druckvorrichtung nach einem der Ansprüche 1 bis 4, welche zusätzlich eine Dekompressionsraumabdichtvorrichtung (44) zum Abdichten des Dekompressionsraums (40) umfasst.

6. Die Druckvorrichtung nach Anspruch 2, wobei der Rahmen (43) die Flüssigkeitsversprühvorrichtungen (6) an Stellen aufweist, die einander quer über das Formziel (2) zugewandt sind.

7. Die Druckvorrichtung nach einem der Ansprüche 1 bis 6, welche zusätzlich eine Temperatureinstellvorrichtung zum Einstellen der Temperatur des Formziels (2) umfasst.

8. Die Druckvorrichtung nach einem der Ansprüche 1 bis 7, welche zusätzlich eine Lichtemissionsvorrichtung (7) zum Abstrahlen von Licht auf das Formziel (2) umfasst.

9. Die Druckvorrichtung nach einem der Ansprüche 1 bis 8, welche zusätzlich eine Tragevorrichtung umfasst, welche eine Förderwalze, die das Formziel (2) zuführt, und eine Sammelwalze, die das Formziel (2) aufnimmt, auf das das Formmodell übertragen wurde, umfasst.

10. Druckverfahren zum Herabdrücken einer Form (1) und eines Formziels (2) zwischen einer Plattform (32) und einer Abdeckung (33) und zum Übertragen eines Formmodells von der Form (1) auf das Formziel (2), wobei das Verfahren einen Anordnungsschritt zum Anordnen der Form (1) und des Formziels (2) auf der Plattform (32) oder der Abdeckung (33);
einen Halteschritt zum Halten von einem von Form (1) und Formziel (2) auf der Deckseite durch einen Rahmen (43), welcher ein Loch aufweist, in das die Plattform (32) eingepasst ist und welcher den Außenumfang der Plattform (32) umgibt, und die Abdeckung (33);
einen Trennschritt zum Trennen der Plattform (32) und der Abdeckung (33) relativ voneinander;
einen ersten Entfernungsschritt zum Entfernen einer Flüssigkeit, die sich in einer Lücke, die zwischen der Abdeckung (32) und der Form (1) oder dem Formziel (2) gebildet wird, befindet;
einen zweiten Entfernungsschritt zum Entfernen einer Flüssigkeit zwischen der Form (1) und dem Formziel (2);
einen Enger-Kontakt-Schritt zum Erreichen, dass die Form (1) und das Formziel (2) in engem Kontakt zueinander stehen; und
einen Übertragungsschritt zum Übertragen des Formmodells von der Form (1) auf das Formziel (2),
umfasst.

11. Das Druckverfahren nach Anspruch 10, welches zusätzlich einen Entformungsschritt zur Bildung einer Lücke zwischen der Form (1) und dem Formziel (2) durch relatives Bewegen der Plattform (32) und des Rahmens (43) und zum Sprühen einer Flüssigkeit aus den Flüssigkeitssprühvorrichtungen (6), die im Rahmen angeordnet sind, in die Lücke umfasst.

12. Das Druckverfahren nach Anspruch 10 oder 11, wobei im Übertragungsschritt das Formziel (2) zu einer Temperatur gleich oder höher als die Glasübergangstemperatur erhitzt wird und das Formziel (2) dann herabgedrückt wird.

13. Das Druckverfahren nach Anspruch 11 oder 12, wobei im Übertragungsschritt die Form (1) und das Formziel (2) niedergedrückt werden und dann Licht auf das Formziel (2) abgestrahlt wird.

## Revendications

1. Dispositif d'impression qui transfère un motif de moulage d'une matrice (1) à une cible de moulage (2), le dispositif d'impression comprenant :
un étage (32) et un couvercle (33) qui enfoncent la matrice (1) et la cible de moulage (2) ;
un cadre (43) muni d'un trou dans lequel l'étage (32) est ajusté et entourant une circonférence externe de l'étage (32) ;
un premier moyen de déplacement pour déplacer de manière relative l'étage (32) et le couvercle (33) dans une direction de manière à se rapprocher ou à s'éloigner l'un de l'autre ;
un deuxième moyen de déplacement pour déplacer de manière relative le couvercle (33) et le cadre (43) dans une direction de manière à se rapprocher ou à s'éloigner l'un de l'autre ;
un premier moyen de dépressurisation (45) pour dépressuriser un espace de dépressurisation (40) formé par l'un(e) quelconque du couvercle (33), de la matrice (1) ou de la cible de moulage (2) et de l'étage (32), et en outre du cadre (43), et pour éliminer un fluide présent entre la matrice (1) et la cible de moulage (2) ; et
un deuxième moyen de dépressurisation (35) pour éliminer un fluide présent dans un espace formé entre le couvercle (33) et la matrice (1) ou la cible de moulage (2).

2. Dispositif d'impression selon la revendication 1, dans lequel le cadre (43) comporte un moyen de pulvérisation de fluide (6) pour pulvériser un fluide entre la matrice (1) et la cible de moulage (2).

3. Dispositif d'impression selon la revendication 1 ou 2, dans lequel le premier moyen de dépressurisation (45) et le deuxième moyen de dépressurisation (35) comportent un canal de communication amenant l'espace et la chambre de dépressurisation (40) à être en communication l'un avec l'autre.

4. Dispositif d'impression selon l'une quelconque des revendications 1 à 3, comprenant en outre un moyen de scellement d'espace (34) pour sceller l'espace.

5. Dispositif d'impression selon l'une quelconque des revendications 1 à 4, comprenant en outre un moyen de scellement (44) de la chambre de dépressurisation pour sceller la chambre de dépressurisation (40).

6. Dispositif d'impression selon la revendication 2, dans lequel le cadre (43) a le moyen de pulvérisation de fluide (6) à des emplacements faisant face les uns aux autres à travers la cible de moulage (2)

7. Dispositif d'impression selon l'une quelconque des revendications 1 à 6, comprenant en outre un moyen de réglage de température pour régler une température de la cible de moulage (2).

8. Dispositif d'impression selon l'une quelconque des revendications 1 à 7, comprenant en outre un moyen d'émission de lumière (7) pour émettre de la lumière vers la cible de moulage (2).

9. Dispositif d'impression selon l'une quelconque des revendications 1 à 8, comprenant en outre un moyen de transport comportant un rouleau d'alimentation qui alimente la cible de moulage (2), et un rouleau de collecte qui collecte la cible de moulage (2) sur laquelle le motif de moulage a été transféré.

10. Procédé d'impression pour enfoncer une matrice (1) et une cible de moulage (2) entre un étage (32) et un couvercle (33), et pour transférer un motif de moulage de la matrice (1) à la cible de moulage (2), le procédé comprenant :
une étape de disposition pour disposer la matrice (1) et la cible de moulage (2) sur l'étage (32) ou le couvercle (33) ;
une étape de maintien pour maintenir l'une ou l'autre de la matrice (1) et de la cible de moulage (2) situées au niveau du côté du couvercle par un cadre (43) muni d'un trou dans lequel l'étage (32) est ajusté et entourant une circonférence externe de l'étage (32), et le couvercle (33) ;
une étape de séparation pour séparer l'étage (32) et le couvercle (33) l'un par rapport à l'autre ;
une première étape d'élimination pour éliminer un fluide présent dans un espace formé entre le couvercle (33) et la matrice (1) ou la cible de moulage (2) ;
une deuxième étape d'élimination pour éliminer un fluide entre la matrice (1) et la cible de moulage (2) ;
une étape de mise en contact intime pour amener la matrice (1) et la cible de moulage (2) en contact intime l'une avec l'autre ; et
une étape de transfert pour transférer le motif de moulage de la matrice (1) à la cible de moulage (2).

11. Procédé d'impression selon la revendication 10, comprenant en outre une étape de démoulage pour former un espace entre la matrice (1) et la cible de moulage (2) en déplaçant de manière relative l'étage (32) et le cadre (43), et pour pulvériser un fluide vers l'espace à partir d'un moyen de pulvérisation de fluide (6) prévu dans le cadre (43).

12. Procédé d'impression selon l'une des revendications 10 ou 11, dans lequel, dans l'étape de transfert, la cible de moulage (2) est chauffée jusqu'à une température supérieure ou égale à une température de transition vitreuse, puis la cible de moulage (2) est enfoncée.

13. Procédé d'impression selon l'une des revendications 11 ou 12, dans lequel, dans l'étape de transfert, la matrice (1) et la cible de moulage (2) sont enfoncées, puis de la lumière est émise vers la cible de moulage (2).
